(19) Europäisches Patentamt
European Patent Office
Office européen des brevets

(11) **EP 1 463 189 B1**

(12) **EUROPÄISCHE PATENTSCHRIFT**

(45) Veröffentlichungstag und Bekanntmachung des Hinweises auf die Patenterteilung:
**02.05.2007 Patentblatt 2007/18**

(51) Int Cl.:
*H02M 3/156* (2006.01) *H03K 17/06* (2006.01)

(21) Anmeldenummer: **04101206.3**

(22) Anmeldetag: **24.03.2004**

(54) **Hilfsspannungsquelle für einen spannungsseitigen NMOS-Transistor**

Auxiliary voltage source for a high side NMOS-transistor

Source de tension auxiliaire pour un transistor de type NMOS connecté du côté de l'alimentation

(84) Benannte Vertragsstaaten:
**DE FR IT SE**

(30) Priorität: **24.03.2003 DE 10313027**

(43) Veröffentlichungstag der Anmeldung:
**29.09.2004 Patentblatt 2004/40**

(73) Patentinhaber: **SIEMENS AKTIENGESELLSCHAFT
80333 München (DE)**

(72) Erfinder:
• **Bolz, Stephan
93102 Pfatter (DE)**
• **Lugert, Günter
93055 Regensburg (DE)**

(56) Entgegenhaltungen:
WO-A-03/065542    US-A- 4 733 159
US-E- R E35 041

• **PATENT ABSTRACTS OF JAPAN vol. 018, no. 434 (E-1592), 12. August 1994 (1994-08-12) -& JP 06 133539 A (FUJITSU LTD), 13. Mai 1994 (1994-05-13)**
• **PATENT ABSTRACTS OF JAPAN vol. 1998, no. 12, 31. Oktober 1998 (1998-10-31) & JP 10 191625 A (MATSUSHITA ELECTRIC IND CO LTD), 21. Juli 1998 (1998-07-21)**

**Beschreibung**

Die Erfindung betrifft eine Spannungsquelle und ein Verfahren zum Betreiben der Hilfsspannungsquelle, sowie eine Schaltungsanordnung zum Schalten einer Last, insbesondere durch einen High-Side-Schalter mit einem N-Kanal-MOS-Transistor.

In der nicht vorveröffentlichten Patentanmeldung DE 10252827 wird eine Schaltungsanordnung zum schnellen Ansteuern von Lasten vorgeschlagen, bei der die Last mittels eines als N-Kanal-MOS-Leistungstransistor ausgeführten und als High-Side-Schalter geschalteten Schalttransistors mit einer Versorgungsspannungsquelle verbindbar ist. Hierbei wird die Gateelektrode des Schalttransistors durch ein ansteuerbares Schaltmittel mit einer die Spannung der Versorgungsspannungsquelle übersteigenden Hilfsspannung beaufschlagt.

Es ist eine Hilfsspannungsquelle bekannt (US R E35, 041), die einen Schalttransistor aufweist, der in Abhängigkeit von einem Ausgangssignal eines Oszillators angesteuert wird. Die bekannte Hilfsspannungsquelle weist weiter eine Strom- und Spannungsbegrenzung auf.

Aufgabe der Erfindung ist es, eine Hilfsspannungsquelle und ein Verfahren zum Betreiben der Hilfsspannungsquelle, sowie eine Schaltungsanordnung zum Schalten einer Last zu schaffen, das sich durch einen einfachen Aufbau und eine hohe elektromagnetische Verträglichkeit (EMV) auszeichnet.

Die Aufgabe der Erfindung wird gelöst durch eine Hilfsspannungsquelle mit den Merkmalen des Anspruchs 1 und ein Verfahren mit den Merkmalen des Anspruchs 4, sowie eine Schaltungsanordnung mit den Merkmalen des Anspruchs 9.

Eine erfindungsgemäße Hilfsspannungsquelle weist einen Energiespeicher auf, der über ein Schaltelement mit einer Versorgungsspannungsquelle verbindbar ist, die eine Versorgungsspannung zur Verfügung stellt. Die Hilfsspannungsquelle liefert eine Hilfsspannung, die größer als die Versorgungsspannung ist.

Eine Überwachungseinrichtung überwacht eine von dem Strom durch den Energiespeicher abhängige Größe und steuert in Abhängigkeit von dieser Größe das Schaltelement an.

Die hier aufgezeigte Hilfsspannungsquelle zeichnet sich durch einen einfachen Aufbau aus elektrischen Standard-Bauelementen aus. Im Gegensatz zu bekannten Hilfsspannungsquellen kann auf den Einsatz von speziellen integrierten Schaltreglern und Transformatoren verzichtet werden.

Die Schaltungsanordnung weist einen hohen Wirkungsgrad auf, wodurch die von der Schaltungsanordnung abgestrahlte Verlustwärme reduziert wird.

In einer bevorzugten Ausführung der Hilfsspannungsquelle erfolgt das Ein- und/oder Ausschalten des Schaltelements in einem stromlosen Zustand, wodurch sowohl die am Schaltelement auftretenden Verluste, wie auch die EMV-Störungen der Hilfsspannungsquelle reduziert werden.

Die erfindungsgemäße Schaltungsanordnung zum Schalten einer Last ermöglicht ein einfaches Ansteuern der Last, wobei die Schaltungsanordnung aus Standard-Komponenten aufgebaut ist, ohne einen Transformator auskommt und einen hohen Wirkungsgrad aufweist.

Vorteilhafte Ausführungsformen der vorliegenden Erfindung sind in den Unteransprüchen angegeben.

In einer Variante wird das Schaltelement ein- und/oder ausgeschaltet, wenn der Strom durch den Energiespeicher einen vorgegebenen Schwellwert über- oder unterschreitet.

Vorzugsweise wird das Schaltelement geschaltet, wenn der Strom durch den Energiespeicher Null ist. Dies hat den Vorteil, dass Schaltflanken des Schalelements einfach zu steuern sind und Rückstromspitzen durch die Hilfsspannungsquelle vermieden werden.

Mehrere Ausführungsbeispiele der Erfindung werden nun anhand von schematischen Zeichnungen näher erläutert. Es zeigen:

| | |
|---|---|
| Figur 1 | ein Blockschaltbild einer erfindungsgemäßen Schaltungsanordnung zum Schalten einer Last, |
| Figur 2 | ein Ausführungsbeispiel einer erfindungsgemäßen Hilfsspannungsquelle, |
| Figur 3a | den zeitlichen Verlauf des Spulenstroms IL1 des in Figur 2 dargestellten Ausführungsbeispiels, |
| Figur 3b | den zeitlichen Verlauf der Spannung UT1D am Drainanschluss des Transistors T1, |
| Figur 3c | den zeitlichen Verlauf der Spannung UR1 über dem Widerstand R1, und |
| Figur 3d | den zeitlichen Verlauf der Spannung an der Basis des Transistors T3. |

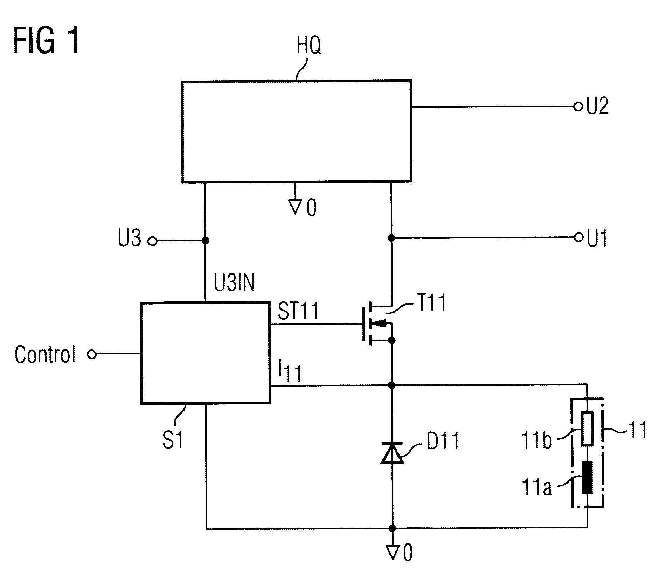

Figur 1 zeigt eine Schaltungsanordnung zum Schalten einer Last 11, die über ein Schaltelement T11 mit einer Versorgungsspannungsquelle U1 verbindbar ist. Die Schaltungsanordnung weist weiter eine Hilfsspannungsquelle HQ, eine Schalteinheit S1 und eine Diode D11 auf.

Die Last 11 kann über ein Schaltelement T11, hier ein als High-Side-Schalter ausgeführter N-Kanal-MOS-Transistor, mit einer ersten Versorgungsspannungsquelle U1 verbunden werden. Die erste Versorgungsspannungsquelle U1 weist hier beispielsweise eine Spannung von 48 Volt auf.

Die Hilfsspannungsquelle HQ stellt an ihrem Hilfsspannungsausgang U3 eine Hilfsspannung zur Verfügung, die größer als die Spannung der ersten Spannungsquelle U1 ist, beispielsweise um 12 V.

Weiter ist die Hilfsspannungsquelle HQ mit Masse und einer zweiten Versorgungsspannungsquelle U2 elektrisch verbunden.

Die Schalteinheit S1 weist mehrere Eingänge auf: einen Steuereingang "Control", einen Hilfsspannungseingang U3IN, der mit dem Spannungsausgang U3 der Hilfsspannungsquelle verbunden ist, und einen Überwachungseingang I11. Weiter weist die Schalteinheit S1 einen Steuerausgang ST11 auf, der mit dem Steueranschluss des Schaltelements T11 elektrisch verbunden ist.

Wird der Steuereingang "Control" von einer nicht dargestellten externen Einheit angesteuert, so wird die Hilfsspannung auf das Gate des Transistors T11 durchgeschaltet. Darauf schaltet der Transistor T11 durch und verbindet die Last 11 mit der Spannungsquelle U1, wodurch die Last 11 mit Energie versorgt wird.

Da das Gate des Transistors T11 mit einer Spannung oberhalb der Versorgungsspannung der ersten Spannungsquelle U1 angesteuert wird, kann hier auch ein n-Kanal-Transistor zum Einsatz kommen.

Bei der Last 11 kann es sich um eine induktive Last, beispielsweise um ein elektromagnetisches Stellglied, insbesondere um ein Einspritzventil einer Brennkraftmaschine, handeln. Die hier dargestellte induktive Last 11 lässt sich durch eine Reihenschaltung aus der eigentlichen Spuleninduktivität 11a, beispielsweise 150 $\mu$H des Elektromagneten und dem Wicklungswiderstand 11b, beispielsweise 0,5 Ohm, beschreiben.

Die Diode D11 hat die Aufgabe, nach dem Ausschalten des Transistors T11 einen Stromfluss zum Entladen der Spuleninduktivität 11a zu ermöglichen.

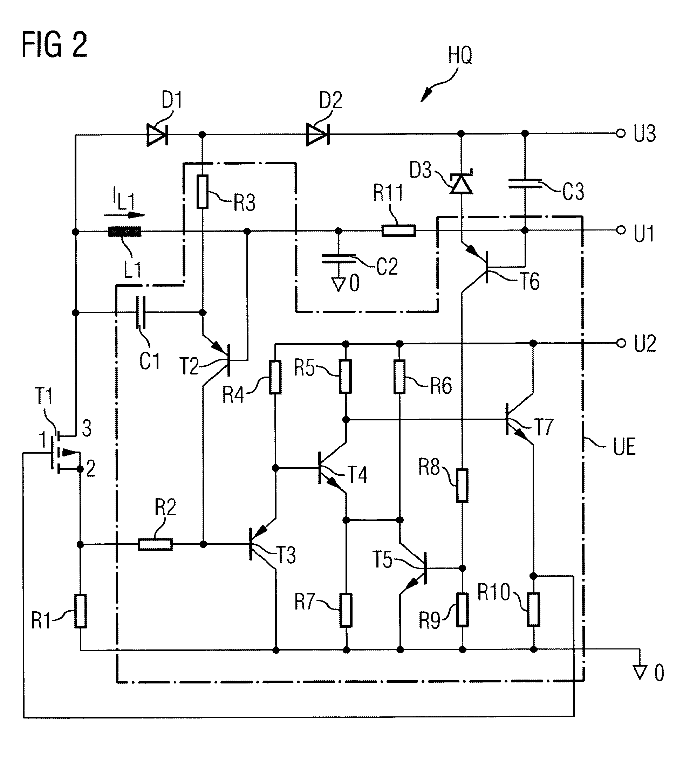

Figur 2 zeigt ein Ausführungsbeispiel einer erfindungsgemäßen Hilfsspannungsquelle HQ.

Zwischen dem Drainanschluss eines Transistors T1, hier beispielsweise ein p-Kanal-MOSFET, und der ersten Spannungsquelle U1 ist ein Energiespeicher, hier eine Induktivität L1 angeordnet. Um zu verhindern, dass der Wechselanteil des durch die Spule L1 fließenden Stroms IL1 in die Versorgungsspannungsquelle U1 fließt, ist hier ein aus einem Kondensator C2 und einem Widerstand R11 bestehendes Tiefpassfilter angeordnet.

Der Sourceanschluss des Transistors T1 ist über einen Widerstand R1 mit Masse verbunden. Der Drainanschluss des Transistors T1 ist weiter über eine erste Diode D1 und eine zweite Diode D2 mit einem Spannungsausgang U3 der Hilfsspannungsquelle HQ verbunden. Die Dioden D1 und D2 sind hier so geschaltet, dass ihre Durchflussrichtung vom Transistor T1 zum Spannungsausgang U3 gerichtet ist.

Die Hilfsspannungsquelle HQ weist weiter eine Überwachungseinrichtung UE auf, die den Transistor T1 abhängig vom Strom IL1 durch die Spule L1 ein- oder ausschaltet. Die Überwachungseinrichtung UE überwacht einen Parameter, der vom Strom IL1 durch die Spule L1 abhängt, beispielsweise die über dem Widerstand R1 abfallende Spannung UR1, und steuert in Abhängigkeit von diesem Parameter den Transistor T1 an.

Die Überwachungseinrichtung UE weist hier einen zweiten Transistor T2 auf, vorzugsweise ein pnp-Transistor, dessen Basis mit dem der ersten Versorgungsspannungsquelle U1 zugewandten Anschluss der Spule L1 verbunden ist und dessen Emitter über einen Kondensator C1 mit dem anderen Anschluss der Spule L1 verbunden ist. Der Kollektor des Transistors T2 ist über einen Widerstand R2 mit dem Sourceanschluss des Transistors T1 verbunden.

Des Weiteren weist die Überwachungseinrichtung einen dritten Transistor T3 auf, ebenfalls vorzugsweise einen pnp-Transistor, dessen Basis mit dem Kollektor des Transistors T2 verbunden ist. Der Emitteranschluss des Transistors T3 ist über einen Widerstand R4 mit der zweiten Versorgungsspannungsquelle U2 - hier mit einer Nennspannung von 5 Volt - elektrisch verbunden. Der Kollektoranschluss des Transistors T3 ist mit Masse verbunden.

Ein vierter Transistor T4, hier ein npn-Transistor, ist mit dem Basisanschluss mit dem Emitteranschluss des Transistors T3 verbunden. Der Kollektoranschluss des Transistors T4 ist über einen Widerstand R5 ebenfalls mit der zweiten Versorgungsspannungsquelle U2 verbunden. Der Emitteranschluss des Transistors T4 ist über einen Widerstand R7 mit Masse verbunden.

Ein fünfter Transistor T5, hier vorzugsweise ein npn-Transistor, ist mit seinem Kollektoranschluss mit dem Emitteranschluss des Transistors T4 und über einen Widerstand R6 mit der zweiten Versorgungsspannungsquelle U2 verbunden. Der Emitteranschluss des Transistors T5 ist mit Masse verbunden. Der Basisanschluss des Transistors T5 ist zum einen über einen Widerstand R9 mit Masse verbunden und zum anderen über einen Widerstand R8 mit dem Kollektoranschluss eines sechsten Transistors T6 verbunden. Der Emitteranschluss des Transistors T6 ist mit dem Kathodenanschluss einer Zenerdiode D3 verbunden, die wiederum mit ihrem Anodenanschluss mit dem Spannungsausgang U3 der Hilfsspannungsquelle verbunden ist. Der Basisanschluss des Transistors T6 ist mit der ersten Versorgungsspannungsquelle U1 verbunden. Ein Kondensator C3 ist einerseits mit dem Spannungsausgang U3 und andererseits mit der ersten Versorgungsspannungsquelle U1 verbunden.

Die Überwachungseinrichtung UE weist weiter einen Transistor T7 auf, hier ein npn-Transistor, der mit seiner Basis mit dem Kollektoranschluss des Transistors T4 verbunden ist und mit seinem Kollektoranschluss mit der zweiten Versorgungsspannungsquelle U2. Der Emitteranschluss des Transistors T7 ist zum einen unmittelbar mit dem Gateanschluss des Transistors T1 und zum anderen über einen Widerstand R10 mit Masse verbunden.

Beim Einschalten der Schaltungsanordnung sei die Spule L1 stromlos und der Transistor T1 ausgeschaltet. Durch den Transistor T1 und die Spule L1 fließt somit kein Strom und die Spannung am Widerstand R1 beträgt 0 Volt.

Die Widerstände R6 und R7 bilden einen Spannungsteiler. An dem Widerstand R6 fällt aufgrund der Spannung der zweiten Versorgungsspannungsquelle U2, hier 5 Volt, eine Spannung von + 250 Millivolt ab.

Aufgrund der Verbindung mit dem Sourceanschluss des Transistors T1 über den Widerstand R2 liegt auch an der Basis des Transistors T3 eine Spannung von 0 Volt an. Die Basisspannung des Transistors T4 beträgt bedingt durch den Spannungsabfall an der Basis-Emitter-Diode des Transistors T3 hier 700 Millivolt.

Die Basis-Emitter-Spannung des Transistors T4 beträgt aufgrund der Differenz zwischen der Basisspannung des Transistors T4 von 700 Millivolt und der am Widerstand R6 des Spannungsteilers abfallenden Spannung von 250 Millivolt hier 450 Millivolt. Der Transistor T4 ist daher ausgeschaltet.

Über den Widerstand R5 wird der Basisanschluss des Transistors T7 mit einer Spannung von 5 Volt angesteuert. Die Emitterspannung des Transistors T7 beträgt nun 4,3 Volt. Da diese Spannung auch am Gateanschluss des Transistors T1 anliegt, wird dieser eingeschaltet.

Somit ist die erste Versorgungsspannungsquelle U1 - hier 48 Volt - nun über die Spule L1, den leitenden Transistor T1 und den Widerstand R1 mit Masse verbunden. Die Spule L1 beginnt sich daher aufzuladen. Der größer werdende Ladestrom IL1 durch die Spule L1 fließt auch durch den Transistor T1 und erzeugt über dem Widerstand R1 einen Spannungsabfall UR1. Diese Spannung UR1 ist zum Strom IL1 proportional. Im hier beschriebenen Ausführungsbeispiel hat der Widerstand R1 einen Wert von 10 Ohm, so dass bei einem Stromfluss von 25 Milliampere am Widerstand R1 eine Spannung UR1 von 250 Millivolt abfällt.

Aufgrund dieses Spannungsabfalls UR1 beträgt die Basisspannung des Transistors T3 dann ebenfalls + 250 Millivolt. Die Basis-Emitter-Spannung des Transistors T4 beträgt nun 700 Millivolt, da sich die Spannungen von + 250 Millivolt und - 250 Millivolt hier kompensieren. Daraufhin schaltet der Transistor T4 durch, was zur Folge hat, dass die Spannung am Kollektoranschluss des Transistors T4 auf eine Spannung < 1 Volt sinkt. Hierdurch sinkt auch die Basisspannung des Transistors T7 und folglich dessen Emitterspannung auf einen Wert von 0,3 Volt. Dies hat nun zur Folge, dass die Gatespannung des Transistors T1 unter dessen Schwellenspannung (threshold voltage) sinkt und der Transistor T1 ausschaltet.

Die Ausschaltzeit von T1 wird hierbei durch die Entladung der Rückwirkungskapazität (Crss) des Transistors T1 und den Strom durch den Widerstand R10 festgelegt.

Um ein erneutes Einschalten des Transistors T1 durch ein Ausschalten des Transistors T4 zu verhindern, wird durch die vom Kollektorstrom des Transistors T2 erzeugten Spannungen an den Widerständen R2 und R4 das Potenzial der Basis des Transistors T3 erhöht, wodurch verhindert wird, dass der Transistor T4 ausschaltet.

Sobald der Transistor T1 ausschaltet, steigt die Spannung an der Spule L1 - getrieben durch die induzierte elektromotorische Kraft der Induktivität - wodurch die Kapazität C1 entladen wird und der Ladestrom durch den Emitter des Transistors T2 fließt und am Widerstand R2 einen positiven Spannungsabfall erzeugt. Somit bleibt der Transistor T4 während der ansteigenden Spannungsflanke der Spannung UL1 über der Spule L1 eingeschaltet.

Wenn die Spannung an der Spule L1 weit genug angestiegen ist, fließt ein Strom über die Dioden D1 und D2 in den Stützkondensator C3. Dieser Stützkondensator C3 puffert die Hilfsspannung am Spannungsausgang U3. Die Spule L1 beginnt sich im Anschluss daran zu entladen. Durch diesen Ladungstransport steigt die Spannung am Kondensator C3 und somit auch die Spannung am Spannungsausgang U3.

Zugleich wird die Spannung am Widerstand R3 auf einen Wert oberhalb der Versorgungsspannung von 48 Volt angehoben, wodurch ein Strom durch den Widerstand R3 und den in Basisschaltung betriebenen Transistors T2 fließt. Dieser Strom erzeugt wiederum an den Widerständen R2 und R1 einen Spannungsabfall, der wiederum den Transistor T4 eingeschaltet hält. Dieser Zustand besteht, bis die Spule L1 vollständig entladen ist und die Spannung an der Spule L1 zusammenbricht. Als Folge davon bricht auch der Stromfluss durch den Widerstand R3, den Transistor T2 und die Widerstände R2 und R1 zusammen, woraufhin der Transistor T4 ausschaltet. Die Kollektorspannung des Transistors T4 steigt nun wieder an, woraufhin der Transistor T1 durch den Transistor T7 wieder eingeschaltet wird und ein neuer Ladezyklus der Spule L1 beginnt.

Der Einschaltvorgang des Transistors T1 erfolgt stromlos, da zu diesem Zeitpunkt die Spule L1 komplett entladen ist und daher kein Strom IL1 fließt. Das Laden und Entladen der Spule L1 wird in Abhängigkeit vom Strom IL1 durch die Spule L1 gesteuert. Dieser Prozess läuft selbständig und periodisch ab, solange die Versorgungsspannungsquellen U1 und U2 eingeschaltet sind.

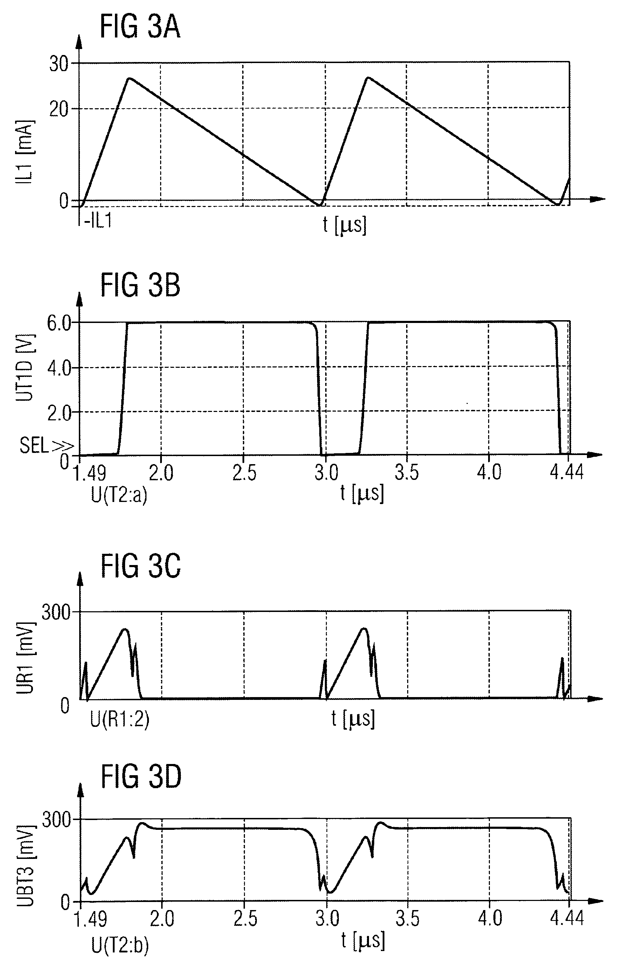

Figur 3a zeigt den Verlauf des durch die Spule L1 fließenden Stromes IL1 in Abhängigkeit von der Zeit t. Die Hilfsspannungsquelle HQ stellt einen selbsttaktenden Schaltregler dar, der einen dreieckförmigen Strom IL1 durch die Spule L1 erzeugt. In der Figur 3b ist der zeitliche Verlauf der Spannung UT1D am Drainanschluss des Transistors T1 aufgetragen.

Die Schaltungsanordnung hat hier den Vorteil, dass der Transistor T1, wie bereits erwähnt, genau dann einschaltet, wenn der Strom IL1 Null ist. Dies bringt weitere positive Effekte mit sich, zum einen fließt im Einschaltaugenblick kein Strom durch die Dioden D1 und D2. Daher kann auch keine - durch die Sperrverzögerungszeit von stromführenden Dioden prinzipbedingte - Rückstromspitze auftreten. Schaltet nämlich der Transistor T1 ein, wenn die Dioden D1 und D2 noch leitend sind, so fließt ein Strom aus dem Kondensator C3 über die Dioden D1 und D2, den Transistor T1 und den Widerstand R1 nach Masse. Dieser Stromfluss kann eine Zerstörung eines elektronischen Bauteils in dem den Rückstrom führenden Pfad zur Folge haben.

Zum anderen verhindert das Einschalten des Transistors T1 im Zeitpunkt der kompletten Entladung der Spule L1, dass Oszillationen an der Spule L1 auftreten. Würde die Spule L1 erst zu einem späteren Zeitpunkt wieder mit einem Ladestrom versorgt, so würde ein Schwingkreis, der aus der Wicklungskapazität der Spule L1 und der Induktivität der Spule L1 besteht, zu schwingen beginnen.

Auf diese Weise werden bei der erfindungsgemäßen Schaltungsanordnung Rückstromspitzen und Oszillationen an der Spule L1 vermieden, die zu EMV-Störungen an anderen elektrischen und elektronischen Bauelementen führen können. Günstig auf das EMV-Störverhalten wirken sich hier der dreieckförmige Eingangsstrom, die einfach zu steuernden Schaltflanken des Transistors T1 und die so verhinderten Rückstromspitzen aus.

Figur 3c zeigt den Verlauf der Spannung UR1, die aufgrund des Stroms IL1 am Widerstand R1 abfällt. Diese Spannung UR1 folgt dem Anstieg des Stroms IL1 bis zu einem Scheitelwert und fällt dann schnell ab. Die Spannungsspitze am Anfang der Ladephase rührt von dem Aufladen der Gatekapazität des Transistors T1 her. Die Spannungsspitze zu Beginn der Entladephase wird durch ein Entladen des Kondensators C1 verursacht.

Figur 3d zeigt den Verlauf der Basisspannung UBT3 des Transistors T3. Das Potenzial der Basis des Transistors T3 ist - während der Transistor T1 ausgeschaltet ist - größer einer Referenzspannung von 250 Millivolt. Dies wird wie bereits oben beschrieben durch den Stromfluss durch den Transistor T2 und den damit verbundenen Spannungsabfall an den Widerständen R2 und R1 verursacht. Somit bleibt der Transistor T4 ausgeschaltet.

Während sich die Spule L1 entlädt steigt die Spannung am Kondensator C3 langsam an. Somit steigt auch die Spannung am Ausgang U3. Erreicht die Hilfsspannung die Größenordnung der Arbeitsspannung UZ der Zenerdiode D3 und die Basis-Emitter-Flussspannung des Transistors T6, so beginnt der Transistor T6 zu leiten und es fließt ein Strom durch die Zenerdiode 3, den Transistor T6 und durch die Widerstände R8 und R9 nach Masse. Übersteigt die Spannung am Widerstand R9 ungefähr 700 Millivolt, so beginnt der Transistor T5 zu leiten. Dies hat zur Folge, dass die Spannung am Knotenpunkt - Kollektoranschluss des Transistors T5 - zwischen den Widerständen R6 und R7 sinkt. Diese Spannung über dem Widerstand R7 dient als Referenzwert für den Aufladevorgang der Spule L1. Ist hier der vorbestimmte Referenzwert erreicht, so wird der Transistor T1 wie bereits beschrieben ausgeschaltet.

Auf diese Weise wird, falls die Spannung UL1 über der Spule L1 groß genug ist, um einen Stromfluss durch die Zehnerdiode D3 und den Widerstand R6 zu verursachen, der Ladestrom der Spule L1 reduziert. Dann wird der Ladestrom IL1 durch die Spule L1 soweit reduziert werden, dass nur noch ein Strom IL1 fließt, der gerade zum Betreiben der aus der Zenerdiode D3, dem Transistor T6 und den Widerständen R8 und R9 bestehenden Regelschleife ausreicht.

Ein Anstieg des abfließenden Stromes am Ausgang U3 führt dazu, dass mittels der oben beschriebenen Regelung die Referenzspannung - die Spannung über dem Widerstand R7 - ansteigt und somit der Ladestrom IL1 der Spule L1 vergrößert wird. Es handelt sich hier somit um eine spannungsgeführte Stromregelung.

Die Schaltfrequenz des Transistors T1 wird in Abhängigkeit vom Endwert des Ladestroms IL1 geregelt, da bei einem kleineren Endwert des Ladestroms IL1 das Auf- und Entladen der Spule L1 eine kürzere Zeit benötigt. Im Gegensatz zur Schaltfrequenz bleibt jedoch die Anstiegsgeschwindigkeit des Ladestroms $\dfrac{dIL1}{dt}$ konstant. Dies bringt enorme Vorteile bei der Auslegung eines Filters gegen EMV-Störungen mit sich, da der Filter somit nur auf die durch diesen Anstieg entstehenden Störungen abgestimmt sein muss. Die Schaltverluste des Transistors T1 bleiben trotz einer wachsenden Schaltfrequenz wegen des abnehmenden Ausschaltstroms in etwa konstant. Die durch die Zenerdiode D3 und den Transistor T6 festgelegte Referenzspannung begrenzt zudem den Ladestrom IL1 auf einen Maximalwert. Auf diese Weise wird der Strom IL1 verzögerungsfrei begrenzt.

Ein weiterer Vorteil der erfindungsgemäßen Schaltungsanordnung ist es, dass auch beim Einschalten des Schaltreglers der Strom begrenzt wird und somit keine Stromspitzen beim Einschalten auftreten. Die Schaltung ermöglicht somit einen sog. Softstart.

Alternativ kann der Anodenanschluss der Diode D2 statt mit dem Kathodenanschluss der Diode D1 mit deren Anodenanschluss verbunden werden. Die Diode D2 ist dann einerseits direkt mit der Spule L1 und andererseits mit dem Spannungsausgang U3 verbunden.

Diese Schaltungsvariante hat bei höheren Ladeströmen IL1 den Vorteil, dass nur über einer Diode, hier der Diode D1, eine Spannung abfällt, so dass die Leitungsverluste halbiert werden.

Alternativ zu dem hier dargestellten Ausführungsbeispiel ist auch ein Betreib der Hilfsspannungsquelle zwischen einem negativen Bezugspotenzial und Masse oder auch zwischen zwei unterschiedlichen Potenzialen denkbar. Hier müsste dann die Transistoren und die Durchlassrichtung der Dioden dementsprechend angepasst werden.

**Patentansprüche**

1. Hilfsspannungsquelle zum Bereitstellen einer Hilfsspannung, insbesondere einer Gate-Spannung für einen N-Kanal-Transistor,

  - die mit einer Versorgungsspannungsquelle (U1) verbindbar ist, die eine Versorgungsspannung zur Verfügung stellt,
- wobei die Hilfsspannung oberhalb der Versorgungsspannung liegt,

die aufweist:

- einen Energiespeicher (L1), der über ein Schaltelement (T1) mit der Versorgungsspannungsquelle (U1) verbindbar ist, und
- eine Überwachungseinrichtung (UE), die eine von dem Strom (IL1) durch den Energiespeicher (L1) abhängige Größe überwacht und in Abhängigkeit von dieser Größe das Schaltelement (T1) ansteuert, wodurch der Energiespeicher (L1) aufgeladen oder entladen wird.

2. Hilfsspannungsquelle nach Anspruch 1, **dadurch gekennzeichnet, dass** das Schaltelement (T1) ein- und/oder ausschaltet, wenn der Strom (IL1) durch den Energiespeicher (L1) einen vorgegebenen Schwellwert über- oder unterschreitet.

3. Hilfsspannungsquelle nach Anspruch 2, **dadurch gekennzeichnet, dass** das Schaltelement (T1) schaltet, wenn der Strom (IL1) durch den Energiespeicher (L1) Null ist.

4. Verfahren zum Betreiben einer Hilfsspannungsquelle,

- bei dem durch die Hilfsspannungsquelle (HQ) eine Hilfsspannung erzeugt wird, die oberhalb einer Versorgungsspannung einer Versorgungsspannungsquelle (U1) liegt, und
- bei dem ein Energiespeicher (L1) über ein Schaltelement (T1) mit einer Versorgungsspannungsquelle (U1) verbunden wird, wobei das Schaltelement (T1) von einer Überwachungseinrichtung (UE) in Abhängigkeit von einem Strom (IL1) durch denen Energiespeicher (L1) gesteuert wird, wodurch der Energiespeicher (L1) aufgeladen oder entladen wird.

5. Verfahren nach Anspruch 4, **dadurch gekennzeichnet, dass** der Strom (IL1) durch den Energiespeicher (L1) reduziert wird, sobald die Hilfsspannung einen vorgegebenen Schwellwert erreicht hat.

6. Verfahren nach einem der Ansprüche 4 oder 5, **dadurch gekennzeichnet, dass** der Strom (IL1) durch den Energiespeicher (L1) auf einen vorgegebenen Maximalwert begrenzt wird.

7. Verfahren nach einem der Ansprüche 4 bis 6, **dadurch gekennzeichnet, dass** das Schaltelement (T1) von der Überwachungseinrichtung (UE) geschaltet wird, wenn kein Strom (IL1) durch den Energiespeicher (L1) fließt.

8. Verfahren nach einem der Ansprüche 4 bis 7, **dadurch gekennzeichnet, dass** in Abhängigkeit von der über dem Energiespeicher (L1) abfallenden Spannung (UL1) der Wiedereinschaltzeitpunkt des Schaltelements (T1) bestimmt wird.

9. Schaltungsanordnung zum Schalten einer Last, mit einer Hilfsspannungsquelle gemäß einem der Ansprüche 1 oder 2, die eine Schalteinheit (S1) aufweist, die einen Schalter (T11) in Abhängigkeit von einem an einem Steuereingang (Control) anliegenden Signal mit einem Spannungsausgang (U3) der Hilfsspannungsquelle (HQ) verbindet, wodurch die Last (11) mit Energie versorgt wird.

10. Schaltungsanordnung nach Anspruch 9, **dadurch gekennzeichnet, dass** der Schalter (T11) als n-Kanal-MOS-Leistungstransistor ausgebildet ist, der als High-Side-Schalter verwendet wird.

11. Schaltungsanordnung nach einem der Ansprüche 9 oder 10, **dadurch gekennzeichnet, dass** die Last (11) eine induktive Last ist.

## Claims

1. Auxiliary power source for providing an auxiliary voltage, in particular a gate voltage for an N-channel transistor,

- which auxiliary power source can be connected to a power supply source (U1) that provides a supply voltage,
- wherein the auxiliary voltage is greater than the supply voltage,

said auxiliary power source comprising:

- an energy store (L1) which can be connected to the power supply source (U1) via a switching element (T1) and
- a monitoring unit (UE) which monitors a variable that is dependent on the current (IL1) through the energy store (L1) and controls the switching element (T1) as a function of said variable, thereby charging or discharging the energy store (L1).

2. Auxiliary power source according to claim 1, **characterised in that** the switching element (T1) switches on and/or off if the current (IL1) through the energy store (L1) exceeds or falls below a specified threshold value.

3. Auxiliary power source according to claim 2, **char-**

**acterised in that** the switching element (T1) switches if the current (IL1) through the energy store (L1) is zero.

4. Method for operating an auxiliary power source,

   - wherein an auxiliary voltage which is greater than a supply voltage of a power supply source (U1) is generated by the auxiliary power source (HQ) and
   - wherein an energy store (L1) is connected to a power supply source (U1) via a switching element (T1), the switching element (T1) being controlled by a monitoring unit (UE) as a function of a current (IL1) through the energy store (L1), thereby charging or discharging the energy store (L1).

5. Method according to claim 4, **characterised in that** the current (IL1) through the energy store (L1) is reduced as soon as the auxiliary voltage has reached a specified threshold value.

6. Method according to one of claims 4 or 5, **characterised in that** the current (IL1) through the energy store (L1) is limited to a specified maximum value.

7. Method according to one of claims 4 to 6, **characterised in that** the switching element (T1) is switched by the monitoring unit (UE) if no current (IL1) flows through the energy store (L1).

8. Method according to one of claims 4 to 7, **characterised in that** the time at which the switching element (T1) is switched back on again is determined as a function of the voltage (UL1) dropping across the energy store (L1).

9. Circuit arrangement for switching a load, said circuit arrangement having an auxiliary power source according to one of claims 1 or 2 and comprising a switching unit (S1) which connects a switch (T11) as a function of a signal present at a control input (Control) to a voltage output (U3) of the auxiliary power source (HQ), thereby supplying the load (11) with energy.

10. Circuit arrangement according to claim 9, **characterised in that** the switch (T11) is embodied as an n-channel MOS power transistor which is used as a high-side switch.

11. Circuit arrangement according to one of claims 9 or 10, **characterised in that** the load (11) is an inductive load.

**Revendications**

1. Source de tension auxiliaire pour fournir une tension auxiliaire, en particulier une tension de grille d'un transistor à canal N,

   - pouvant être raccordée à une source de tension d'alimentation (U1) qui fournit une tension d'alimentation,
   - la tension auxiliaire étant supérieure à la tension d'alimentation,

   comprenant:

   - un accumulateur d'énergie (L1) pouvant être connecté à la source de tension d'alimentation (U1) via un élément de commutation (T1), et
   - un dispositif de surveillance (UE) qui surveille une grandeur dépendant du courant (IL1) s'écoulant par l'accumulateur d'énergie (L1) et qui commande l'élément de commutation (T1) en fonction de cette grandeur ce qui fait se charger ou se décharger l'accumulateur d'énergie (L1).

2. Source de tension auxiliaire selon la revendication 1, **caractérisée en ce que** l'élément de commutation (T1) s'enclenche ou se déclenche quand le courant (IL1) à travers l'accumulateur d'énergie (L1) dépasse vers le haut ou vers le bas une valeur de seuil prédéterminée.

3. Source de tension auxiliaire selon la revendication 2, **caractérisée en ce que** l'élément de commutation (T1) commute quant le courant (IL1) s'écoulant dans l'accumulateur d'énergie (L1) est nul.

4. Procédé pour la mise en oeuvre d'une source de tension auxiliaire,

   - dans lequel une tension auxiliaire supérieure à la tension d'alimentation fournie par une source de tension d'alimentation (U1) est générée par la source de tension auxiliaire (HQ), et
   - dans lequel un accumulateur d'énergie (L1) est connecté via un élément de commutation (T1) à une source de tension d'alimentation (U1), l'élément de commutation (T1) étant commandé par un dispositif de surveillance (UE) en fonction d'un courant (IL1) s'écoulant à travers un accumulateur d'énergie (L1) ce qui charge ou décharge l'accumulateur d'énergie (L1).

5. Procédé selon la revendication 4, **caractérisé en ce que** le courant (IL1) à travers l'accumulateur d'énergie (L1) est réduit dès que la tension auxiliaire a atteint une valeur de seuil prédéterminée.

**6.** Procédé selon l'une des revendications 4 ou 5, **caractérisé en ce que** le courant (IL1) à travers l'accumulateur d'énergie (L1) est limité à une valeur maximale prédéterminée.

**7.** Procédé selon l'une des revendications 4 à 6, **caractérisé en ce que** l'élément de commutation (T1) est commuté par le dispositif de surveillance (UE) lorsqu'aucun courant ne traverse l'accumulateur d'énergie (L1).

**8.** Procédé selon l'une des revendications 4 à 7, **caractérisé en ce que** le moment de réenclenchement de l'élément de commutation (T1) est déterminé en fonction de la tension (UL1) chutant sur l'accumulateur d'énergie (L1).

**9.** Dispositif de commutation de charge, comprenant une source de tension auxiliaire selon l'une des revendications 1 ou 2, et qui comporte une unité de commutation (S1) connectant un commutateur (T11) à une sortie de tension (U3) de la source de tension auxiliaire (HQ) en fonction d'un signal appliqué à une entrée de commande (Control), ce qui alimente la charge (11) en énergie.

**10.** Dispositif de commutation selon la revendication 9, **caractérisé en ce que** le commutateur (T11) est réalisé sous forme de transistor de puissance MOS à canal n utilisé comme interrupteur "High-Side" qui est connecté à la tension.

**11.** Dispositif de commutation selon l'une des revendications 9 ou 10, **caractérisé en ce que** la charge (11) est une charge inductive.

# FIG 1

FIG 2

## FIG 3A

## FIG 3B

## FIG 3C

## FIG 3D